# EUROPEAN PATENT APPLICATION

(11) **EP 4 752 882 A2**
(43) Date of publication of application: **03.06.2026**
(21) Application number: 25211146.3
(22) Date of filing: 24.10.2025
(51) Int. Cl.: G11C 7/10

(54) **MEMORY DEVICE, MEMORY CONTROLLER, AND OPERATING METHOD OF MEMORY SYSTEM INCLUDING THE MEMORY DEVICE AND THE MEMORY CONTROLLER**

(30) Priority: 02.12.2024 KR 20240176877
(71) Applicant: Samsung Electronics Co., Ltd., Suwon-si, Gyeonggi-do 16677 (KR)
(72) Inventor: YUN, Sewon, 16677 Suwon-si (KR); KO, Kuihan, 16677 Suwon-si (KR); BANG, Jinbae, 16677 Suwon-si (KR); YOO, Hyunyoung, 16677 Suwon-si (KR); YUN, Jungyun, 16677 Suwon-si (KR); HAN, Sangjoon, 16677 Suwon-si (KR)
(74) Representative: Marks & Clerk LLP

(57) **Abstract**

The present disclosure relates to a memory device (200), a memory controller (100), and a memory system including the memory device (200) and the memory controller (100). An example memory device (200) may include a memory cell array (210) including a plurality of memory cells and control logic configured to control, with respect to the memory cell array (210), a memory operation corresponding to a status read command-address signal transmitted from the memory controller (100) external to the memory device (200), where the control logic is further configured to, in response to the status read command-address signal, transmit a pass/fail status signal and a ready/busy status signal to the memory controller (100), and the pass/fail status signal and the ready/busy status signal respectively include a pass/fail status and a ready/busy status of the memory device (200).

## Description

### BACKGROUND

As information and communication devices become multi-functional, there is a high demand for higher capacity and higher integration of memory systems. Recently developed memory systems may be configured to transmit commands and addresses through a command address (CA) bus and data through a DQ bus according to a separate command address (SCA) protocol. By separating the buses as described above, the I/O efficiency of the memory system may be improved. The I/O efficiency of the memory system may be improved by transmitting data to one memory chip through the DQ bus while transmitting commands and addresses to another memory chip through the CA bus.

### SUMMARY

The present disclosure relates to a memory device, a memory controller, and an operating method of the memory controller, wherein the memory device is capable of reading bits of a first status read command-address signal provided from the memory controller, starting from a high-priority bit, so that malfunction of the memory device may be prevented and the status of the memory device may be clearly determined, thereby improving data reliability.

The invention provides a memory device including, a memory cell array including a plurality of memory cells, and control logic configured to control, with respect to the memory cell array, a memory operation corresponding to a status read command-address signal transmitted from a memory controller external to the memory device, wherein the control logic is further configured to, in response to the status read command-address signal, transmit a pass/fail status signal and a ready/busy status signal to the memory controller, and the pass/fail status signal and the ready/busy status signal respectively include a pass/fail status and a ready/busy status of the memory device.

The invention also provides a memory controller for controlling a memory device including, a memory interface configured to transfer a status read command-address signal for controlling a memory operation for the memory device to the memory device through a first bus, and transmit and receive data corresponding to the status read command-address to and from the memory device through the second bus, and a processor configured to receive the status data of the memory device from the memory device through the second bus while a pass/fail status signal and a ready/busy status signal are transferred to the memory controller, in response to the status read command-address signal, wherein the pass/fail status signal and the ready/busy status signal respectively include a pass/fail status and a ready/busy status of the memory device.

The invention also provides an operating method of a memory system, including a memory controller and a memory device, the method including, transmitting, by the memory controller, a status read command-address signal through a first bus to control an operation of the memory device, transmitting and receiving, by the memory controller, data corresponding to the status read command-address signal through a second bus, receiving, by the memory device, the status read command-address signal to detect status data of the memory device, and transferring, by the memory device, the status data to the memory controller, wherein the status data includes a pass/fail status and a ready/busy status of the memory device.

At least some of the above and other features of the invention are set out in the claims.

### BRIEF DESCRIPTION OF THE DRAWINGS

Implementations will be more clearly understood from the following detailed description taken in conjunction with the accompanying drawings.
FIG. 1 is a block diagram of an example of a host-memory system.
FIG. 2 is a block diagram of an example of a memory controller.
FIG. 3 is a block diagram of an example of a memory device.
FIG. 4 is a block diagram illustrating an example of a separate command address (SCA) protocol.
FIG. 5 is a timing diagram illustrating example signals.
FIG. 6 is a flowchart of an example of an operating method of a memory system.
FIG. 7 is a timing diagram illustrating example signals.
FIG. 8 is a flowchart of an example of an operating method of a memory system.
FIG. 9 is a block diagram of an example control logic.
FIG. 10 is a timing diagram illustrating example signals.
FIG. 11 is a block diagram of an example of a system including a memory device.

### DETAILED DESCRIPTION

Hereinafter, implementations are described in detail with reference to the accompanying drawings.

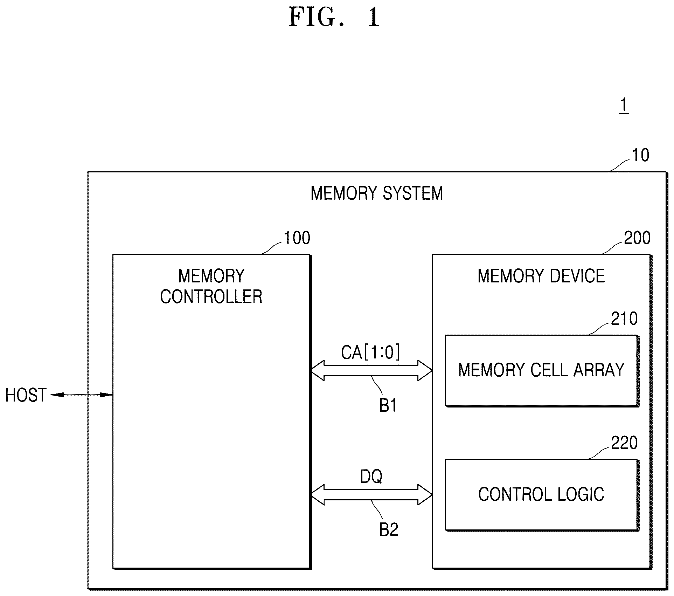

FIG. 1 is a block diagram of an example of a host-memory system 1.

Referring to FIG. 1, the host-memory system 1 may include a host and a memory system 10. The memory system 10 may include a memory controller 100 and a memory device 200, wherein the memory device 200 may include a memory cell array 210 and control logic 220 (also referred to as a control circuit).

The host may communicate with the memory system 10 through an interface. The interface may be implemented as, e.g., non-volatile memory express (NVMe), NVMe management interface (NVMe MI), or NVMe over fabric (NVMeof). The host may control the overall operation of the memory system 10. For example, the host may store data in the memory system 10 or read data stored in the memory system 10.

The host may send a write request to the memory system 10 requesting the memory system 10 to store data. In addition, the host may send data and a logical address for identifying data to the memory system 10. The host may send a read request to the memory system 10 requesting the memory system 10 to transmit data stored therein. In addition, the host may send the logical address for identifying data to the memory system 10.

The memory system 10 may include the memory controller 100 and the memory device 200. For example, the memory controller 100 and the memory device 200 may be integrated into one semiconductor device. For example, the memory system 10 may be implemented as internal memory embedded in an electronic device and may include an embedded universal flash storage (UFS) memory device, an embedded multimedia card (eMMC), or a solid-state drive (SSD). In some implementations, the memory system 10 may be implemented as external memory removable from an electronic device and may include, for example, a UFS memory card, a compact flash (CF), a secure digital (SD), a micro-SD, a mini-SD, and an extreme digital (xD), or a memory stick.

The memory controller 100 may control the memory device 200 to read data stored in the memory device 200 or to write (or program) data to the memory device 200 in response to a request (e.g., a read request or a write request) received from the host.

The memory controller 100 may control a write operation (or a program operation), a read operation, and an erase operation for the memory device 200 by sending a command and an address as a command-address signal CA[1:0] to the memory device 200. In addition, data to be written and data to be read may be exchanged between the memory controller 100 and the memory device 200 as a data signal DQ.

In some implementations, the command-address signal CA[1:0] sent by the memory controller 100 to the memory device 200 may include a status read command-address signal. For example, the memory controller 100 may read the status of the memory device 200 by transmitting the status read command-address signal to the memory device 200. Hereinafter, it is assumed that the command-address signal CA[1:0] is the status read command-address signal. The command-address signal CA[1:0] may be referred to as a status read command-address signal CA [1: 0].

The memory controller 100 may communicate with the host and the memory device 200. The memory controller 100 may communicate with the host through various standard interfaces. For example, the memory controller 100 may include a host interface, wherein the host interface may provide various standard interfaces between the host and the memory controller 100. The standard interfaces may include various interface schemes, such as advanced technology attachment (ATA), serial ATA (SATA), external SATA (e-SATA), small computer small interface (SCSI), serial attached SCSI (SAS), peripheral component interconnect (PCI), PCI express (PCI-E), IEEE 1394, universal serial bus (USB), SD card, MMC, eMMC, UFS, CF card interface, and the like.

The memory controller 100 may include a memory interface, wherein the memory interface may transfer the status read command-address signal CA[1:0] to the memory device 200. The memory interface may transmit the data signal DQ to be written to the memory device 200 or may receive the data signal DQ read from the memory device 200. The memory interface may be implemented to comply with a standard protocol, such as Toggle or open NAND flash interface (ONFI).

The memory controller 100 may transfer a command and an address to the memory device 200 through buses B1 and B2. For example, the memory controller 100 may provide the status read command-address signal CA[1:0] to the memory device 200 through the first bus B1. The first bus B1 is referred to as a command-address bus and the second bus B2 may be referred to as a data bus. The status read command-address signal CA[1:0] may refer to a data-related command-address. The data-related command-address may refer to a signal accompanying input/output operations of operational data through a data bus while the memory device 200 performs an operation instructed by the command-address. Examples of the data related command-address may include a read command and a write command. In addition, in some implementations, the examples of the data related command-address may also include an erase command or other commands related to the data bus initiated by a separate command address (SCA) protocol.

The status read command-address signal CA[1:0] may include command-address information necessary for the memory controller 100 to instruct the memory device 200 to operate. The command-address information may include command information and address information. The status read command-address signal CA[1:0] may include a first status read command-address signal CA[1] and a second command-address signal. The first status read command-address signal CA[1] may include n bits (n is a natural number of 2 or greater). For example, the first status read command-address signal CA[1] may include 8 bits. A seventh bit CA[1][6] may store a ready/busy status signal of the memory device 200 and a first bit CA[1][0] may store a pass/fail signal of the memory device 200. This is merely for convenience of description and is not necessarily limited thereto.

The memory controller 100 may transmit and receive the operation data to and from the memory device 200 through the buses B1 and B2. The operation data may refer to data to be written to the memory device 200 and data read from the memory device 200. The memory system 10 may perform a direct memory access (DMA) operation. The memory controller 100 may perform the DMA operation for transmitting the operation data to the memory device 200 or receiving the operation data from the memory device 200. The memory device 200 may perform the DMA operation for receiving the operation data from the memory controller 100 or transmitting the operation data to the memory controller 100.

For example, the memory controller 100 may perform the DMA operation through the second bus B2. The memory controller 100 may transmit and receive the data signal DQ to and from the memory device 200 through the second bus B2. The memory controller 100 may transmit and receive the operation data to and from the memory device 200 by using the data signal DQ. For example, the memory controller 100 may transmit the data signal DQ to the memory device 200 through the second bus B2 during the write operation. The memory controller 100 may receive the data signal DQ from the memory device 200 through the second bus B2 during the read operation. The data signal DQ may include the operation data.

The memory controller 100 may control the overall operation of the memory device 200. The memory controller 100 may control a memory operation for the memory device 200. The memory operation for the memory device 200 may include the write operation, the read operation, the erase operation, and the like. The memory controller 100 may transmit the status read command-address signal CA[1:0] and the data signal DQ to perform the memory operation for the memory device 200.

The memory device 200 may include a NVM device, such as a flash memory. The flash memory may include a two-dimensional (2D) NAND memory array or a three-dimensional (3D) (or vertical) NAND (VNAND) memory array. In some implementations, the 3D memory array may include vertically arranged VNAND strings such that at least one memory cell is located above another memory cell. The at least one memory cell may include a charge trap layer.

The present disclosure is not limited thereto. The memory device 200 may include other various types of memory. For example, the memory device 200 may include NVM, and various types of memory, such as magnetic random access memory (MRAM), spin-transfer torque MRAM, conductive bridging RAM (CBRAM), ferroelectric RAM (FeRAM), phase-change RAM (PRAM), resistive RAM, nanotube RAM, polymer RAM (PoRAM), nano floating gate memory (NFGM), holographic memory, molecular electronic memory, or insulator resistance change memory may be applied to the NVM.

The memory device 200 may include the memory cell array 210 and the control logic 220. For example, the memory device 200 may include a plurality of chips. In some implementations, the memory device 200 may be referred to as a chip, a NAND chip, a semiconductor chip, a memory chip, or the like. The memory cell array 210 may include a plurality of memory blocks. Each memory block may include a plurality of memory cells arranged in regions where a plurality of word lines intersect with a plurality of bit lines. In the memory cell array 210, the erase operation of data may be performed on a cell block basis and the write and read operations of data may be performed on a page basis.

The control logic 220 may control the overall operation of the memory device 200. The control logic 220 may control the memory device 200 to perform an operation based on at least one of the command, the address, and the operation data.

The control logic 220 may receive the status read command-address signal CA[1:0] from the memory controller 100 through the first bus B1. The control logic 220 may control the memory operation of the memory device 200 based on the status read command-address signal CA[1:0] provided from the first bus B1.

The control logic 220 may transmit and receive the operation data to and from the memory controller 100. The control logic 220 may transmit and receive the operation data corresponding to the status read command-address signal CA[1:0] to and from the memory controller 100 through the second bus B2. For example, the control logic 220 may receive the status read command-address signal CA[1:0] of the read operation through the first bus B1 and transfer the data signal DQ including read operation data corresponding to the read operation to the memory controller 100 through the second bus B2.

The memory cell array 210 may be driven to perform the program operation, the read operation, and the erase operation under the control by the control logic 220.

The memory device 200 may be provided with the status read command-address signal CA[1:0] from the memory controller 100 to perform the program operation. The access to the memory device 200 may be prohibited by outputting a ready/busy signal from the start to the end of the program operation.

According to some implementations, the memory device 200 may perform the program operation to store data. For example, the program operation may be performed by varying a threshold voltage of memory cells included in the memory device 200. When the threshold voltage of the memory cells does not correspond to the data to be stored, the program operation may fail. Conversely, when the threshold voltage of the memory cells corresponds to the data to be stored, the program operation may pass. The data to be stored in the memory cells until the program operation ends may be stored in the memory controller 100 or the memory device 200.

According to some implementations, the memory device 200 may output a status signal to the memory controller 100 through the first bus B1 or the second bus B2. For example, the memory device 200 may output a busy status signal to the memory controller 100 while an internal operation (e.g., the program operation) is performed. The busy status signal may have a logic low level. The memory device 200 may output a ready status signal to the memory controller 100 while any operation (e.g., the program operation) is not performed. The ready status signal may have a logic high level.

In some implementations, the memory controller 100 may provide the status read command-address signal CA[1:0] to the memory device 200 to determine whether the program operation has passed and/or whether the memory device 200 is performing the internal operation.

In some implementations, the memory device 200 may provide a ready/busy status signal and a pass/fail signal to the memory controller 100 through the first bus B1 or the second bus B2. A time point at which the memory device 200 provides the pass/fail signal to the memory controller 100 is earlier than a time point at which the memory device 200 provides the ready/busy status signal to the memory controller 100. Thereafter, when the memory controller 100 transmits a status read command to the memory device 200 to read the status of the memory device 200, a fail signal may be output even when the memory device 200 is in a pass status.

To solve such a problem, the memory device 200, according to some implementations, may read bits of the first status read command-address signal CA[1] provided from the memory controller 100, starting from a high-priority bit. The high-priority bit may include a bit including the ready/busy status signal among bits of the first status read command-address signal CA[1]. For example, the bit including the ready/busy status signal may have a higher priority than the bit including the pass/fail signal.

In addition, the memory device 200 according to some implementations may temporarily store the first status read command-address signal CA[1] provided from the memory controller 100. The memory device 200 may provide status signals (e.g., chip status, ready/busy status, and pass/fail status) of the memory device 200 to the memory controller 100 after a specific time point at which the first status read command-address signal CA[1] is stored.

In response to the first status read command-address signal CA[1:0] provided from the memory controller 100, the memory device 200 according to some implementations may determine whether to re-perform the status read operation by using an additional bit when the ready/busy status signal and/or the pass/fail signal is changed.

The control logic 220 may output status detection data. The control logic 220 may transfer the status detection data to the outside of the memory device 200. The control logic 220 may transfer the status detection data to the memory controller 100. The control logic 220 may transfer the status detection data to the memory controller 100 based on the status read command transmitted from the memory controller 100.

The memory device 200 according to some implementations may read bits of the first status read command-address signal CA[1] from the memory controller 100, starting from the high-priority bit. The high-priority bit may include a bit including the ready/busy status signal among bits of the first status read command-address signal CA[1]. That is, as the memory device 200 reads the high-priority bit, the status of the memory device 200 may be more clearly distinguished, thereby improving the reliability of data.

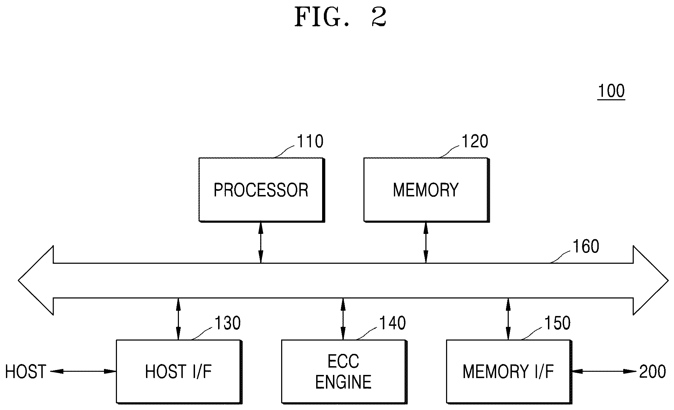

FIG. 2 is a block diagram of an example of a memory controller 100. Since the memory controller 100 of FIG. 2 corresponds to the memory controller 100 in FIG. 1, descriptions that are substantially the same as those given above may be omitted.

Referring to FIG. 2, the memory controller 100 may include a processor 110, memory 120, a host interface 130, an ECC engine 140, and a memory interface 150. The memory controller 100 may further include other components as needed. For example, the components of the memory controller 100 may communicate with each other through bus 160.

The processor 110 may include a central processing unit (CPU), a microprocessor, or the like, and may control the overall operation of the memory controller 100. In some implementations, the processor 110 may be implemented as a multi-core processor. For example, the processor 110 may be implemented as a dual-core processor or a quad-core processor. For example, the processor 110 may execute instruction code of firmware stored in the memory 120.

The processor 110 may receive status detection data. The processor 110 may receive the status detection data through the memory interface 150. The processor 110 may determine whether to re-perform the status read operation based on whether the status is detected.

According to some implementations, the processor 110 may be implemented in software, firmware, and/or hardware. In some implementations, the processor 110 may be implemented in software. The memory controller 100 may further include working memory loaded with the processor 110 and may control the processor 110 to re-perform the status read operation according to the status detection data. For example, the working memory may be implemented as volatile memory, such as static RAM (SRAM) and dynamic RAM (DRAM), or NVM, such as flash memory and PRAM.

The memory 120 may be used as operation memory, buffer memory, cache memory, or the like. For example, the memory 120 may be implemented as DRAM, SRAM, PRAM, or flash memory. When the memory 120 is used as buffer memory, the memory 120 may temporarily store the operation data to be written to the memory device 200 or the operation data to be read from the memory device 200. The memory 120 may be provided in the memory controller 100 but may also be arranged outside the memory controller 100. For example, the memory controller 100 may further include a buffer memory manager or a buffer memory interface to communicate with the memory 120.

The host interface 130 may transmit and receive a packet to and from the host. The packet transmitted from the host to the host interface 130 may include a command or data to be written to the memory device 200 and the packet transmitted from the host interface 130 to the host may include a response to the command or data read from the memory device 200.

The ECC engine 140 may perform error detection and correction functions on the data read from the memory device 200. More specifically, the ECC engine 140 may generate parity bits for write operation data to be provided to the memory device 200, wherein the generated parity bits may be stored in the memory device 200 together with the write operation data. When the data is read from the memory device 200, the ECC engine 140 may correct an error in the read data by using the parity bits read from the memory device 200 together with the read data and may output the read data in which the error is corrected.

The memory interface 150 may provide an interface between the memory controller 100 and the memory device 200. For example, data, commands, and addresses may be exchanged between the memory controller 100 and the memory device 200 through the memory interface 150.

The bus 160 may operate based on one of a variety of bus protocols. The variety of bus protocols may include at least one of an advanced microcontroller bus architecture (AMBA) protocol, a USB protocol, an MMC protocol, a PCI protocol, a PCI-E protocol, an ATA protocol, a serial-ATA protocol, a parallel-ATA protocol, a SCSI protocol, an enhanced small disk interface (ESDI) protocol, an integrated drive electronics (IDE) protocol, a mobile industry processor interface (MIPI) protocol, and a UFS protocol.

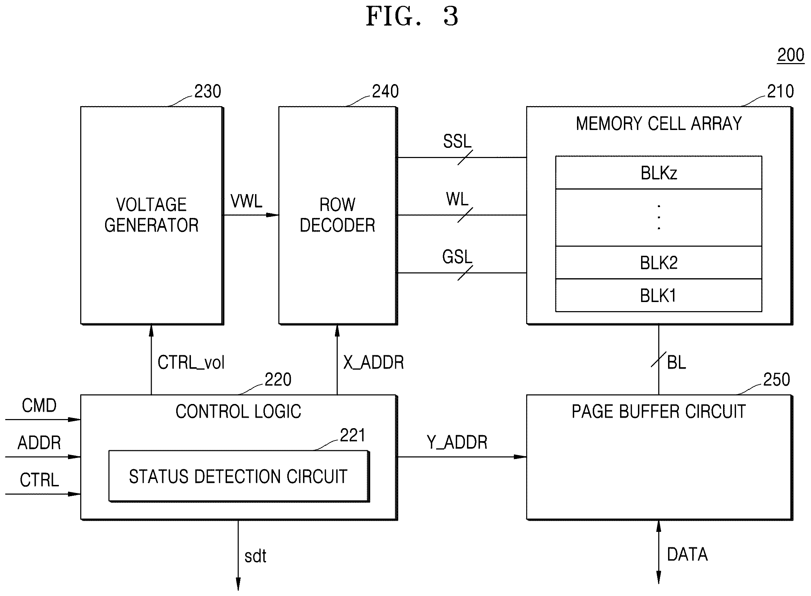

FIG. 3 is a block diagram of an example of a memory device 200. Descriptions that are substantially the same as those given in FIG. 1 may be omitted.

Referring to FIG. 3, the memory device 200 may include a memory cell array 210, control logic 220, a voltage generator 230, a row decoder 240, and a page buffer circuit 250.

The memory cell array 210 may include a plurality of memory cells and may be connected to word lines WL, string selection lines SSL, ground selection lines GSL, and bit lines BL. Specifically, the memory cell array 210 may be connected to the row decoder 240 through the word lines WL, the string selection lines SSL, and the ground selection lines GSL, and may be connected to the page buffer circuit 250 through the bit lines BL.

The memory cell array 210 may include a plurality of memory blocks. For example, each of the plurality of memory blocks may include a plurality memory cells. Each of the plurality of memory blocks may have a 3D (or vertical) structure. The plurality of memory blocks may be selected by the row decoder 240. For example, the row decoder 240 may select a memory block corresponding to a block address from among the plurality of memory blocks.

The control logic 220 may control the overall operations of the memory device 200. For example, the control logic 220 may output various control signals for writing data to or reading data from the memory cell array 210, based on a command CMD, an address ADDR, and a control signal CTRL. For example, the control logic 220 may output a voltage control signal CTRL_vol, a row address X_ADDR, and a column address Y_ADDR. The various control signals output from the control logic 220 may be provided to the voltage generator 230, the row decoder 240, and the page buffer circuit 250. The control logic 220 may provide the voltage control signal CTRL_vol to the voltage generator 230.

The control logic 220 may be connected to a first bus (e.g., the first bus B1 in FIG. 1). The control logic 220 may receive the command CMD and the address ADDR through the first bus B1. The control logic 220 may receive a command-address signal (e.g., the status read command-address signal CA[1:0] in FIG. 1) through the first bus B1, wherein the status read command-address signals CA[1:0] may include the command CMD and the address ADDR.

In some implementations, the control logic 220 may include a status detection circuit 221. The status detection circuit 221 may detect status data of the memory device 200 during a status read operation to generate status detection data sdt. For example, the status detection circuit 221 may detect the status data at a specific time point or every specific time point during the status read operation. However, the present disclosure is not necessarily limited thereto.

The status detection circuit 221 may store the status detection data sdt in a latch circuit. In some implementations, the latch circuit may be included in the control logic 220, but is not limited thereto. The latch circuit may also be included outside the control logic 220.

The status detection circuit 221 may transfer the status detection data sdt to the outside of the memory device 200. For example, the status detection circuit 221 may control the latch circuit to output the status detection data sdt. The status detection data sdt may be transmitted to the memory controller 100 through the first bus B1. In FIG. 3, the status detection circuit 221 is illustrated as being included in the control logic 220, but is not necessarily limited thereto. The status detection circuit 221 may be separate from the control logic 220.

The voltage generator 230 may generate various kinds of voltages for performing write, read, and erase operations on the memory cell array 210 based on the voltage control signal CTRL _vol. Specifically, the voltage generator 230 may generate a word line voltage VWL, for example, a write voltage, a read voltage, an erase voltage, and the like. For example, during a read operation, the voltage generator 230 may generate the read voltage under the control by the control logic 220 and provide the read voltage to the row decoder 240. In addition, the voltage generator 230 may further generate a string selection line voltage and a ground selection line voltage based on the voltage control signal CTRL_vol.

The row decoder 240 may select a specific word line from among the word lines WL in response to the row address X_ADDR received from the control logic 220. For example, during the read operation, the row decoder 240 may provide the read voltage to the selected word line. In addition, the row decoder 240 may select some of the string selection lines SSL or some of the ground selection lines GSL in response to the row address X_ADDR received from the control logic 220.

The page buffer circuit 250 may be connected to the memory cell array 210 through the bit lines BL. The page buffer circuit 250 may select some of the bit lines BL in response to the column address Y_ADDR received from the control logic 220. The page buffer circuit 250 may temporarily store data read from the memory cell array 210. During the read operation, the page buffer circuit 250 may sense operation data DATA read from the memory cell array 210 and temporarily store the read operation data DATA. The page buffer circuit 250 may temporarily store the operation data DATA to be stored in the memory cell array 210.

In some implementations, the page buffer circuit 250 may be connected to a second bus (e.g., the second bus B2 in FIG. 1). The page buffer circuit 250 may transmit and receive the operation data DATA to and from a memory controller through the second bus B2. The page buffer circuit 250 may transmit the operation data DATA to the memory controller (e.g., the memory controller 100 in FIG. 1) through the second bus B2 or may receive the operation data DATA from the memory controller through the second bus B2. The page buffer circuit 250 may receive a data signal (e.g., the data signal DQ of FIG. 1) through the second bus B2, wherein the data signal DQ may include the operation data DATA.

The page buffer circuit 250 may include a plurality of page buffers respectively connected to the bit lines BL. The plurality of page buffers may be arranged corresponding to the bit lines, respectively. Each of the plurality of page buffers may include a plurality of latches. The page buffer circuit 250 may be defined to include a page buffer coupled to each bit line. However, in some implementations, terms may be defined differently. As an example, one page buffer may be provided corresponding to a plurality of bit lines, and a unit of a component arranged corresponding to each bit line may be defined as a page buffer unit.

The memory device 200 according to some implementations may read bits of the first status read command-address signal CA[1] provided from the memory controller 100, starting from the bit including the ready/busy status signal which is the high-priority bit.

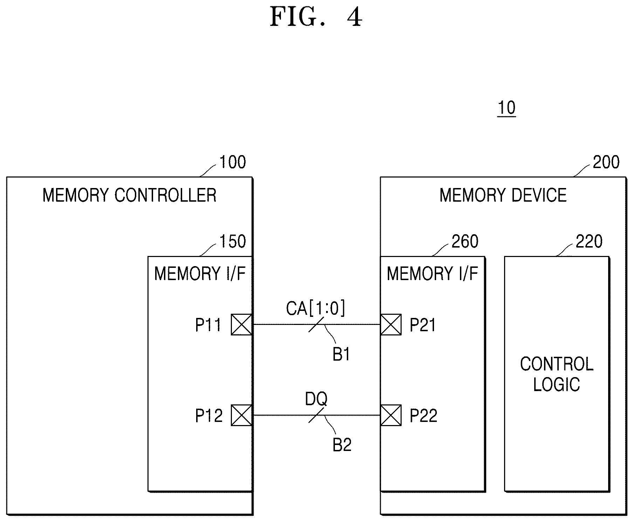

FIG. 4 is a block diagram of an example of a memory system.

Specifically, FIG. 4 is a diagram illustrating an SCA protocol. Since a memory system 10, a memory controller 100, a memory device 200, and control logic 220 in FIG. 4 correspond to the memory system 10, the memory controller 100, the memory device 200, and the control logic 220 in FIG. 1, descriptions that are substantially the same as those given above may be omitted.

Referring to FIG. 4, the memory system 10 includes the memory controller 100 and the memory device 200, wherein the memory device 200 may communicate with the memory controller 100 based on buses B1 and B2.

The memory controller 100 may include a memory interface 150. The memory controller 100 may include a first pin P11 and a second pin P12. The memory device 200 may include a first pin P21 and a second pin P22. The first pin P11 and the second pin P12 may correspond to the first pin P21 and the second pin p22, respectively. The first pins P11 and P21 may be connected to the first bus B1 and the second pins P12 and P22 may be connected to the second bus B2. The memory controller 100 and the memory device 200 exchange signals through the first pin P11, the second pin P12, the first pin P21, and the second pin P22.

The first pins P11 and P21 may include two signal lines including a first status read command-address signal CA[1] and a second status read command-address signal CA[0]. The second pins P12 and P22 may include n signal lines corresponding to a bit size of the data signal DQ. For example, when the bit size of the data signal DQ exchanged through the second pins P12 and P22 is 8 bits, the second pins P12 and P22 may include 8 signal lines.

Although FIG. 4 illustrates that the memory controller 100 and the memory device 200 each include two pins, this is for convenience of description and is not necessarily limited thereto. For example, the memory system 10 may further include pins and buses for transmitting a chip enable signal (CE), a command latch enable signal (CLE), an address latch enable signal (ALE), and the like.

The memory interface 150 of the memory controller (100) may transmit the status read command-address signal CA[1:0] to the memory device 200 through the first pin P11. Then, the memory interface 150 may transmit the data signal DQ to the memory device 200 through the second pin P12 or may receive the data signal DQ from the memory device 200.

The memory device 200 may include a memory interface 260 and control logic 220. The memory interface 260 may receive the status read command-address signal CA[1:0] from the memory controller 100 through the first pin P21. The command and the address may be transferred through the status read command-address signal CA[1:0]. Then, the memory interface 260 may transmit the data signal DQ to the memory controller 100 through the second pin P22 or may receive the data signal DQ from the memory controller 100. For example, the operation data may be transferred from the memory controller 100 to the memory device 200 through the data signal DQ. The sensed operation data may be transferred from the memory device 200 to the memory controller 100 through the data signal DQ.

The control logic 220 may detect the status data while the data signal DQ is exchanged through the second pin P22 and may generate the status detection data. The control logic 220 may transmit the status detection data through the memory interface 260.

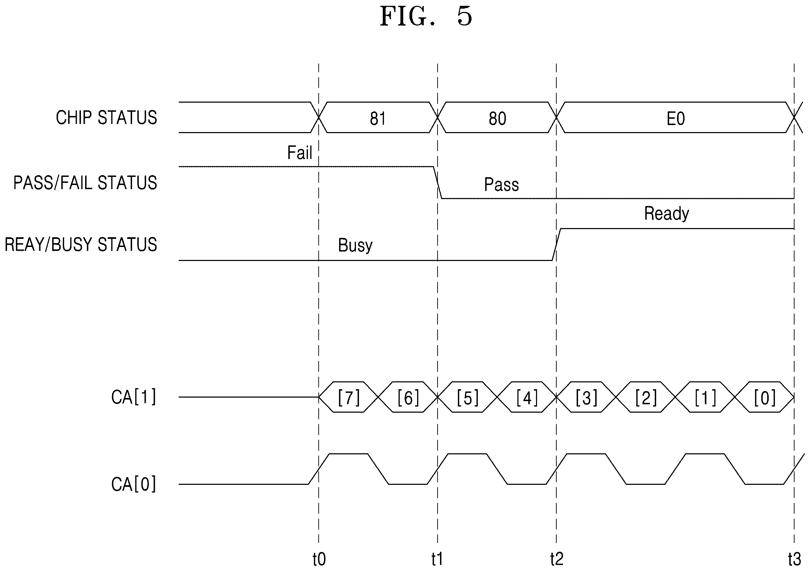

FIG. 5 is a timing diagram illustrating example signals.

Specifically, FIG. 5 shows the status read command-address signal CA[1:0], and the chip status signal, the pass/fail status signal, and the ready/busy status signal of the memory device. In FIG. 5, the horizontal axis represents time. Descriptions that are substantially the same as those given above may be omitted.

Referring to FIGS. 4 and 5, the memory controller 100 may transmit the status read command-address signal CA[1:0] to the memory device 200 through the first bus B1 and may transmit or receive data through the second bus B2. The status read command-address signal CA[1:0] may include a first status read command-address signal CA[1] and a second status read command-address signal CA[0]. For example, the size of the first status read command-address signal CA[1] may be n bits (n is a natural number of 2 or greater). Hereinafter, description is made on the assumption that the size of the first status read command-address signal CA[1] is 8 bits. In some implementations, the memory device 200 may include a plurality of chips.

The memory device 200 may transmit the chip status signal, the pass/fail status signal, and the ready/busy status signal to the memory controller 100 through the first bus B1 or the second bus B2.

At a first time point t0, the memory device 200 may have the pass/fail status signal at a logic high level. For example, when the pass/fail status signal is at a logic high level, it may indicate a fail status, and when the pass/fail status signal is at a logic low level, it may indicate a pass status. However, the present disclosure is not necessarily limited thereto. When the pass/fail status signal is at a logic high level, it may indicate a pass status, and when the pass/fail status signal is at a logic low level, it may indicate a fail status.

At the first time point t0, the memory device 200 may have the ready/busy status signal at a logic low level. For example, when the ready/busy status signal is at a logic low level, it may indicate a busy status, and when the ready/busy status signal is at a logic high level, it may indicate a ready status. However, the present disclosure is not necessarily limited thereto. When the ready/busy status signal is at a logic low level, it may indicate a ready status, and when the ready/busy status signal is at a logic high level, it may indicate a busy status.

That is, at the first time point t0, the memory device 200 may be in a fail status and may be in a busy status.

At a second time point t1, the memory device 200 may transition the pass/fail status signal from a logic high level to a logic low level.

At the second time point t1, the memory device 200 may have the ready/busy status signal at a logic low level.

That is, at the second time point t1, the memory device 200 may be in a pass status and may be in a busy status.

At a first interval t0 to t1, the memory device 200 may provide the first status read command-address signal CA[1] to the memory controller 100. For example, the seventh bit CA[1][6] of the first status read command-address signal CA[1] may include the ready/busy status signal of the memory device 200. Accordingly, in the first interval t0 to t1, the memory controller 100 may receive status data indicating that the memory device 200 in in a fail status and in a busy status.

In the first interval t0 to t1, the chip status of the memory device 200 may indicate busy fail 81, which may be provided as status data to the memory controller 100.

At a third time point t2, the memory device 200 may transition the ready/busy status signal from a logic low level to a logic high level.

At the third time point t2, the memory device 200 may maintain the pass/fail status signal at a logic low level.

That is, at the third time point t2, the memory device 200 is in a pass status and may be in a busy status.

In the second interval t1 to t2, the memory device 200 may provide a sixth bit CA[1][5] and a fifth bit CA[1][4] of the first status read command-address signal CA[1] to the memory controller 100.

In the second interval t1 to t2, the chip status of the memory device 200 may indicate busy pass 80, which may be provided as status data to the memory controller 100.

In a third interval t2 to t3, the memory controller 100 may provide fourth to first bits CA[1][3] to CA[1][0] of the first status read command-address signal CA[1] to the memory device 200. For example, the first bit CA[1][0] of the first status read command-address signal CA[1] may include the pass/fail status signal of the memory device 200. Accordingly, in the third interval t2 to t3, the memory controller 100 may receive status data indicating that the busy status of the memory device 200 is changed to the ready status.

In the third interval t2 to t3, the chip status of the memory device 200 may indicate ready pass E0.

Referring to FIG. 5, the seventh bit CA[1][6] of the bits of the first status read command-address signal CA[1] may include the ready/busy status signal, and the first bit CA[1][0] may include the pass/fail status signal. For example, since the priority of the seventh bit CA[1][6] is higher than the priority of the first bit CA[1][0], the memory device 200 may provide the seventh bit CA[1][6] to the memory controller 100 before the first bit CA[1][0].

Referring to FIG. 5, since the memory device 200 first transmits a bit corresponding to the seventh bit CA[1][6] to be transmitted to the memory controller 100 and then transmits a bit corresponding the first bit CA[1][0], the memory controller 100 may determine that the status of the memory device 200 is busy pass.

That is, referring to FIG. 5, since the memory controller 100 receives the busy pass 80 as the chip status of the memory device 200, the memory device 200 may re-perform the operation of transmitting the status read command-address signal CA[1:0] to the memory controller 100.

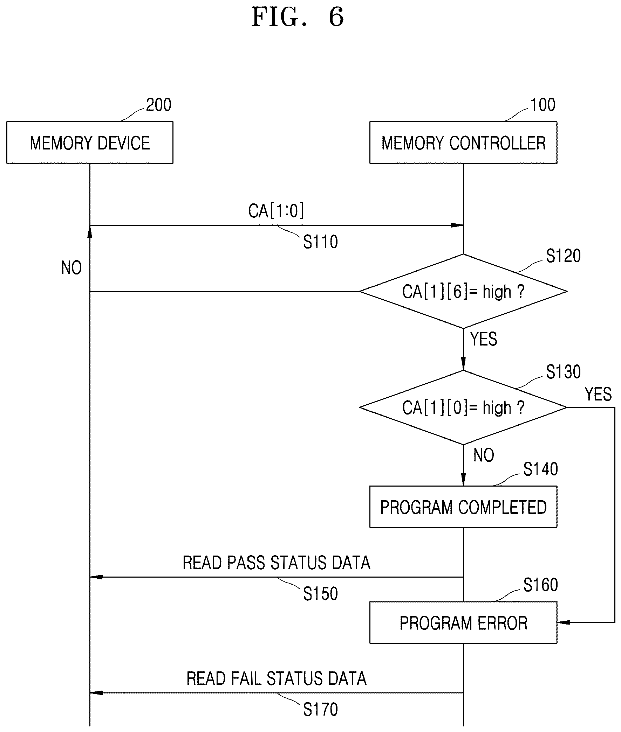

FIG. 6 is a flowchart of an example of an operating method of a memory system.

Referring to FIGS. 1 and 6, in operation S110, the memory device 200 may transfer the status read command-address signal CA[1:0] to the memory controller 100. The memory device 200 may provide the status read command-address signal CA[1:0] to the memory controller 100 through the first bus B1. For example, the status read command-address signal CA[1:0] may include the first status read command-address signal CA[1] and the second status read command-address signal CA[0], wherein the first status read command/address signal CA[1] may include 8 bits. The memory device 200 may receive the status read command-address signal CA[1:0] from the memory controller 100.

In operation S120, the memory controller 100 may determine whether the logic level of the seventh bit CA[1][6] of the first status read command-address signal CA[1] is a logic high level. For example, the memory controller 100 may determine the ready/busy status of the memory device 200 based on the logic level of the seventh bit CA[1][6] of the first status read command-address signal CA[1] received from the memory device 200. For example, when the bit level of the seventh bit CA[1][6] is a logic high level, it may indicate that the memory device 200 is in a ready status, and when the logic level of the seven bit CA[1][6] is in a logic low level, it may indicate that the memory device 20 is in a busy status. For example, when the bit value of the seventh bit CA[1][6] of the first status read command-address signal CA[1] is 1, the bit level of the seventh bit CA[1][6] corresponds to a logic high level, which may indicate that the memory device 200 is in a ready status. For example, when the bit value of the seventh bit CA[1][6] of the first status read command-address signal CA[1] is 0, the bit level of the seventh bit CA[1][6] corresponds to a logic low level, which may indicate that the memory device 200 is in a busy status.

When the logic level of the seventh bit CA[1][6] of the first status read command-address signal CA[1] is a logic high level (YES in S120), e.g., when the bit value of the seventh bit CA[1][6] is 1, the memory controller 100 may perform operation S130.

When the bit level of the seventh bit CA[1][6] of the first status read command-address signal CA[1] is not a logic high level (NO in S120), e.g., when the bit level of the seventh bit CA[1][6] is a logic low level or when the bit value of the seventh bit CA[1][6] is 0, the memory controller 100 may perform operation S110 again. For example, referring to FIG. 5, since the chip status of the memory device 200 is busy pass 80, the memory device 200 may re-perform operation S110 of transmitting the status read command-address signal CA[1:0] to the memory controller 100.

In operation S130, the memory controller 100 may determine whether the logic level of the first bit CA[1][0] of the first status read command-address signal CA[1] is a logic high level. For example, the memory controller 100 may determine the pass/fail status of the memory device 200 based on the logic level of the first bit CA[1][0] of the first status read command-address signal CA[1] received from the memory device 200. For example, when the logic level of the first bit CA[1][0] is a logic high level, it may indicate that the memory device 200 is in a fail status, and when the logic level thereof is a logic low level, it may indicate that the memory device 200 is in a pass status. For example, when the bit value of the first bit CA[1][0] of the first status read command-address signal CA[1] is 1, the bit value corresponds to a logic high level, which may indicate that the memory device 200 is in a fail status. For example, when the bit value of the first bit CA[1][0] of the first status read command-address signal CA[1] is 0, the bit value corresponds to a logic low level, which may indicate that the memory device 200 is in a pass status.

When the logic level of the first bit CA[1][0] of the first status read command-address signal CA[1] is a logic low level (NO in S130), e.g., when the bit value of the first bit CA[1][0] is 0, the memory controller 100 may perform operation S140.

In operation S140, the memory device 200 may complete the program operation. For example, when the threshold voltage of the memory cells included in the memory device 200 has a threshold voltage corresponding to data to be stored, the program operation may pass.

In operation S150, the memory device 200 may transfer pass status data to the memory controller 100. The memory device 200 may transfer pass status data to the memory controller 100 through the second bus B2.

When the logic level of the first bit CA[1][0] of the first status read command-address signal CA[1] is a logic high level (YES in S130), e.g., when the bit value of the first bit CA [1][0] is 0, the memory device 200 may perform operation S160.

In operation S160, the memory device 200 may not complete the program operation. For example, when the threshold voltage of the memory cells included in the memory device 200 does not have a threshold voltage corresponding to data to be stored, the program operation may fail.

In operation S170, the memory device 200 may transmit fail status data to the memory controller 100. The memory device 200 may transmit the fail status data to the memory controller 100 through the second bus B2.

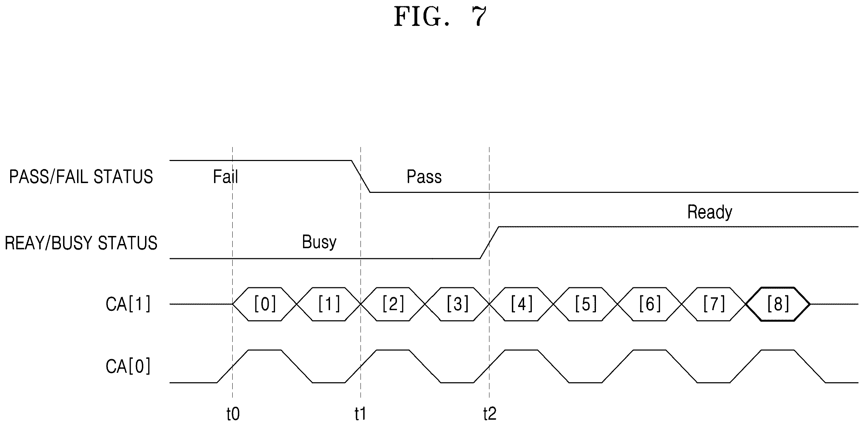

FIG. 7 is a timing diagram illustrating example signals.

Specifically, FIG. 7 shows the status read command-address signal CA[1:0], and the pass/fail signal and ready/busy status signal of the memory device. In FIG. 7, the horizontal axis represents time. Descriptions that are substantially the same as those given above may be omitted.

Referring to FIG. 7, unlike FIG. 5, the bit size of the first status read command-address signal CA[1] may be 9 bits. Hereinafter, it is assumed that the bit size is 9 bits.

In addition, referring to FIG. 7, unlike FIG. 5, the memory controller 100 may sequentially transmit bits of the first status read command-address signal CA[1] to the memory device 200, starting from the first bit CA[1][0] to the ninth bit CA[1][8].

Referring to FIGS. 4 and 7, the memory controller 100 may transmit the status read command-address signal CA[1:0] to the memory device 200 through the first bus B1 and may transmit or receive data through the second bus B2. The status read command-address signal CA[1:0] may include the first status read command-address signal CA[1] and the second status read command-address signal CA[0].

The memory device 200 may transmit a pass/fail status signal and a ready/busy status signal to the memory controller 100 through the first bus B1 or the second bus B2.

At a first time point t0, the memory device 200 may have a pass/fail status signal at a logic high level. For example, when the pass/fail status signal is at a logic high level, it may indicate a fail status, and when the pass/fail status signal is at a logic low level, it may indicate a pass status. However, the present disclosure is not necessarily limited thereto. When the pass/fail status signal is at a logic high level, it may indicate a pass status, and when the pass/fail status signal is at a logic low level, it may indicate a fail status.

At the first time point t0, the memory device 200 may have a ready/busy status signal at a logic low level. For example, the ready/busy status signal may indicate a busy status when the signal is at a logic low level and may indicate a ready status when the signal is at a logic high level. However, the present disclosure is not necessarily limited thereto. The ready/busy status signal may indicate a ready status when the signal is at a logic low level and may indicate a busy status when the signal is at a logic high level.

That is, at the first time point t0, the memory device 200 may be in a fail status and may be in a busy status.

At a first interval t0 to t1, the memory controller 100 may provide the first status read command-address signal CA[1] to the memory device 200. For example, the first bit CA[1][0] of the first status read command-address signal CA[1] may include the pass/fail status signal of the memory device 200. Accordingly, in the first interval t0 to t1, the memory controller 100 may receive status data indicating that the memory device 200 is in a fail status and in a busy status.

At a second time point t1, the memory device 200 may transition the pass/fail status signal from a logic high level to a logic low level.

At the second time point t1, the memory device 200 may maintain the ready/busy status signal at a logic low level.

That is, at the second time point t1, the memory device 200 is in a pass status and may be in a busy status.

At a third time point t2, the memory device 200 may transition the ready/busy status signal from a logic low level to a logic high level.

At the third time point t2, the memory device 200 may maintain the pass/fail status signal at a logic low level.

That is, at the third time point t2, the memory device 200 may be in a pass status and may be in a ready status.

In a second interval t1 to t2, the memory controller 100 may provide the third bit CA[1][2] and the fourth bit CA[1][3] of the first status read command-address signal CA[1] to the memory device 200.

After the third time point t2, the memory controller 100 may provide the fifth to the ninth bits CA[1][4] to CA[1][8] of the first status read command-address signal CA[1] to the memory device 200. For example, the seventh bit CA[1][6] of the first status read command-address signal CA[1] may include a ready/busy status signal of the memory device 200. Accordingly, after the third time point t2, the memory controller 100 may receive the status data indicating that the busy status of the memory device 200 is changed to the ready status thereof. When the pass/fail status signal and/or the ready/busy status signal of the memory device 200 is changed, the ninth bit CA[1][8] may store 1 as the bit value of the ninth bit CA[1][8], and when the pass/fail status signal and/or the ready/busy status signal of the memory device 200 is not changed, the ninth bit CA[1][8] may store 0 as the bit value of the nine bit CA[1][8]. For example, the bit value of the ninth bit CA[1][8] may be stored as 1 when the pass/fail status signal of the memory device 200 is changed, and the bit value of the ninth bit CA[1][8] may be stored as 0 when the pass/fail status signal is not changed.

For example, when the bit value of the ninth bit CA[1][8] is 1, the memory controller 100 may re-perform the operation of transmitting the status read command-address signal CA[1:0] to the memory device 200. For example, when the bit value of the ninth bit CA[1][8] is 0, the memory controller 100 may not re-perform the operation of transmitting the status read command-address signal CA[1:0] to the memory device 200.

Referring to FIGS. 4 and 7, the memory controller 100 may sequentially provide whether the first bit CA[1][0] of the first status read command-address signal CA[1], the ready/busy status signal of the seventh bit CA[1][6], and the pass/fail status signal of the ninth bit CA[1][8] are changed to the memory device 200.

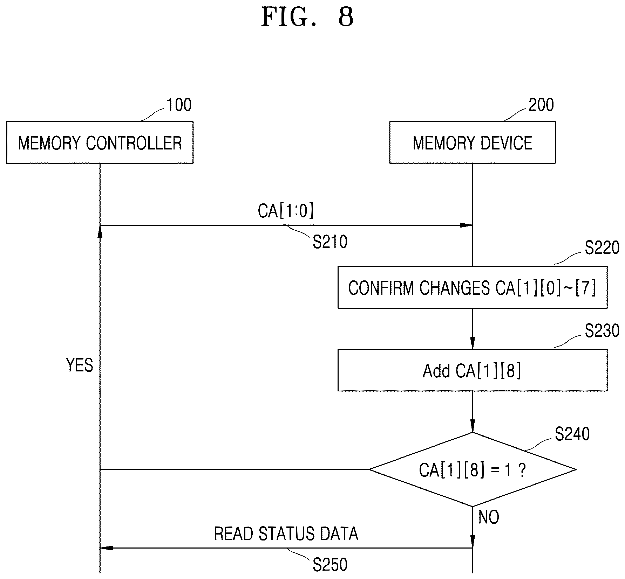

FIG. 8 is a flowchart of an example of an operating method of a memory system.

Referring to FIGS. 1 and 8, in operation S210, the memory controller 100 may transfer the status read command-address signal CA[1:0] to the memory device 200. The memory controller 100 may provide the status read command-address signal CA[1:0] to the memory device 200 through the first bus B1. For example, the status read command-address signal CA[1:0] may include the first status read command-address signal CA[1] and the second status read command-address signal CA[0], wherein the first status read command-address signal CA [1] may include 9 bits.

In operation S220, the memory device 200 may determine whether bit values of the first to eighth bits CA[1][0] to CA[1][7] of the first status read command-address signal CA[1] are changed. For example, it may be confirmed whether the bit value of the pass/fail status signal which is the first bit CA[1][0] is changed or the bit value of the ready/busy status signal which is the seventh bit CA[1][6] is changed.

In operation S230, the memory device 200 may add a bit value to the ninth bit of the first status read command-address signal CA[1]. For example, when the pass/fail status signal of the memory device 200 is changed, the bit value may be stored as 1 in the ninth bit CA[1][8], and when the pass/fail status signal is not changed, the bit value may be stored as 0 in the ninth bit CA[1][8].

In operation S240, the memory device 200 may determine whether the bit value of the ninth bit CA[1][8] of the first status read command-address signal CA[1] is 1.

When the bit value of the ninth bit CA[1][8] of the first status read command-address signal CA[1] is 1 (YES of S240), the memory device 200 may perform operation S210. For example, when the status of the memory device 200 changes from fail to pass, the memory controller 100 may re-perform operation S210 of transmitting the status read command-address signal CA[1:0] to the memory device 200.

When the bit value of the ninth bit CA[1][8] of the first status read command-address signal CA[1] is 0 (NO in S240), the memory device 200 may perform operation S250. For example, when the status of the memory device 200 does not change from fail to pass, that is, when the fail status is maintained, the memory device 200 may transmit the status data to the memory controller 100 (S250).

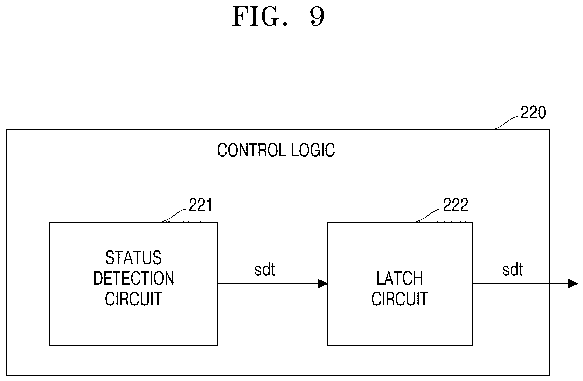

FIG. 9 is a block diagram of an example control logic. Control logic 220 may be included in a memory device (e.g., the memory device 200 of FIG. 1). Descriptions that are substantially the same as those given above may be omitted.

Referring to FIG. 9, the control logic 220 may include a status detection circuit 221 and a latch circuit 222. The status detection circuit 221 may generate status detection data sdt by detecting the status data. The status detection circuit 221 may store the status detection data sdt in the latch circuit 222.

The latch circuit 222 may store the status detection data sdt. In some implementations, the latch circuit 222 may be included in the control logic 220, but is not necessarily limited thereto. The latch circuit 222 may be included outside the control logic 220. The status detection circuit 221 may transmit the status detection data sdt to the outside of the memory device 200.

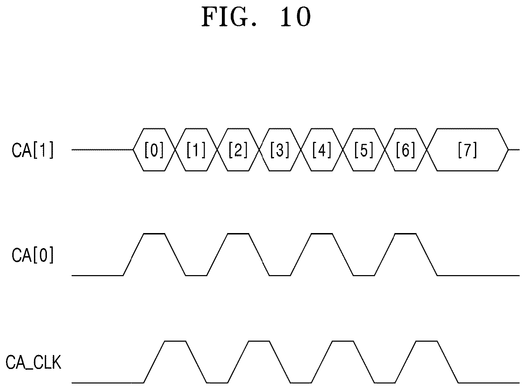

FIG. 10 is a timing diagram illustrating example signals.

Specifically, FIG. 10 shows a status read command-address signal CA[1:0] and a clock signal CA_CLK of the command-address. In FIG. 10, the horizontal axis represents time. Descriptions that are substantially the same as those given above may be omitted.

Referring to FIG. 10, unlike FIG. 5, the bit size of the first status read command-address signal CA[1] may be 8 bits. It is assumed that the bit size is 8 bits.

In addition, referring to FIG. 10, the memory controller 100 may sequentially transmit bits of the first status read command-address signal CA[1] to the memory device 200, starting from the first bit CA[1][0] to the eighth bit CA[1][7].

Referring to FIGS. 4 and 10, the control logic 220 may store the status detection data in the latch circuit 222 by detecting the status data at a specific time point during toggling of the clock signal CA_CLK of the command-address. When the memory controller 100 provides the first status read command-address signal CA[1] to the memory device 200, the memory device 200 may provide the status detection data sdt stored in the latch circuit 222 to the memory controller 100.

According to some implementations, when the memory device 200 receives the first status read command-address signal CA[1], the control logic 220 may detect the status data and store the status detection data sdt in the latch circuit 222. When the memory controller 100 provides the first status read command-address signal CA[1] to the memory device 200, the memory device 200 may provide the status detection data sdt stored in the latch circuit 222 to the memory controller 100.

After the memory device 200 receives the first status read command-address signal CA[1], the control logic 220 according to some implementations may detect the status data and before the memory device 200 transmits the data to the memory controller 100, and may store the status detection data in the latch circuit 222.

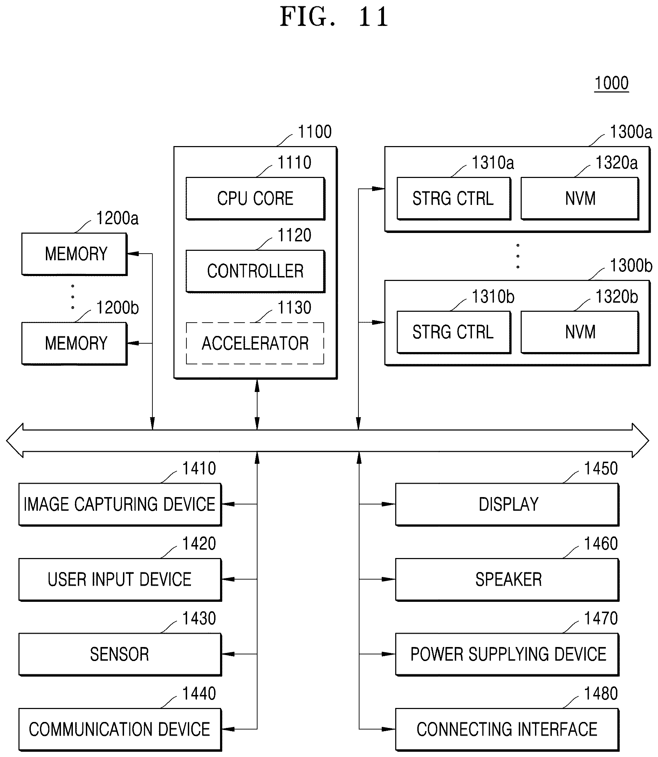

FIG. 11 is a block diagram of an example of a system including a memory device. NVM devices 1320a and 1320b of FIG. 11 may include the memory device described in the present disclosure (e.g., the memory device 200 of FIG. 1). Storage devices 1300a and 1300b in FIG. 11 may include the memory system described in the present disclosure (e.g., the memory system 10 of FIG. 1). A system 1000 of FIG. 11 may include basically a mobile system, such as a mobile phone, a smartphone, a tablet personal computer (PC), a wearable device, a healthcare device, or an internet of things (IOT) device. However, the system 1000 of FIG. 11 is not necessarily limited to the mobile system. The system 1000 of FIG. 11 may include a PC, a laptop computer, a server, a media player, an automotive device such as navigation, or the like.

Referring to FIG. 11, the system 1000 may include a main processor 1100, memories 1200a and 1200b, and storage devices 1300a and 1300b, and may further include one or more of an image capturing device 1410, a user input device 1420, a sensor 1430, a communication device 1440, a display 1450, a speaker 1460, a power supplying device 1470, and a connecting interface 1480.

The main processor 1100 may control the overall operation of the system 1000, and more specifically, the operation of the other components of the system 1000. The main processor 1100 may be implemented as a general-purpose processor, a dedicated processor, an application processor, or the like.

The main processor 1100 may include one or more CPU cores 1110 and may further include a controller 1120 for controlling the memories 1200a and 1200b and/or the storage devices 1300a and 1300b. According to some implementations, the main processor 1100 may further include an accelerator 1130 which is a dedicated circuit for high-speed data operation, such as artificial intelligence (AI) data operation. The accelerator 1130 may include a graphics processing unit (GPU), a neural processing unit (NPU), and/or a data processing unit (DPU), and may be implemented as a separate chip physically independent of other components of the main processor 1100.

The memories 1200a and 1200b may be used as the main memory of the system 1000 and may include volatile memory, such as SRAM and/or DRAM, and may also include NVM, such as flash memory, PRAM, and/or RRAM. The memories 1200a and 1200b may also be implemented in the same package as main processor 1100.

The storage devices 1300a and 1300b may function as non-volatile storage devices that store data regardless of whether power is supplied and may have a relatively large storage capacity, compared to the memories 1200a and 1200b. The storage devices 1300a and 1300b may include memory controllers 1310a and 1310b and NVM devices 1320a and 1320b that store data under the control by the memory controllers 1310a and 1310b. The NVM devices 1320a and 1320b may include flash memory of a 2D structure or a 3D V-NAND structure but may also include other types of NVM, such as PRAM and/or RRAM. The memory device (e.g., the memory device 200 of FIG. 1) described with reference to FIGS. 1 to 10 may be applied to the NVM devices 1320a and 1320b in FIG. 11.

The storage devices 1300a and 1300b may be included in the system 1000 while being physically separate from the main processor 1100 or may be implemented in the same package as the main processor 1100. In addition, the storage devices 1300a and 1300b may have a form, such as an SSD(Solid State Drive) or a memory card, and may be detachably coupled to other components of the system 1000 through an interface, such as a connecting interface 1480 to be described below. The storage devices 1300a and 1300b may include devices to which a standard protocol, such as UFS, eMMC, or NVMe, is applied, but are not necessarily limited thereto.

The image capturing device 1410 may capture a still image or a moving image, and may include a camera, a camcorder, and/or a webcam. The user input device 1420 may receive various types of data input from a user of the system 1000 and may include a touchpad, a keypad, a keyboard, a mouse, and/or a microphone. The sensor 1430 may sense various types of physical quantities that can be obtained from the outside of the system 1000, and may convert the sensed physical quantities into electrical signals. The sensor 1430 may include a temperature sensor, a pressure sensor, an illuminance sensor, a position sensor, an acceleration sensor, a biosensor, and/or a gyroscope sensor.

The communication device 1440 may exchange signals with other devices outside the system 1000 according to various communication protocols. The communication device 1440 may include an antenna, a transceiver, and/or a modem. The display 1450 and the speaker 1460 may each function as output devices that outputs visual information and auditory information, respectively, to the user of the system 1000. The power supplying device 1470 may appropriately convert power supplied from a battery built in the system 1000 and/or an external power source and supply the power to each component of the system 1000.

The connecting interface 1480 may provide a connection between the system 1000 and an external device connected to the system 1000 to exchange data with the system 1000. The connecting interface 1480 may be implemented in various interface manners, such as ATA, SATA, e-SATA, SCSI, SAS, PCI, PCIe, NVMe, IEEE 1394, USB, SD card, MMC, eMMC, UFS, embedded UFS (eUFS), CF card interface, and the like.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While the present disclosure has been shown and described with reference to implementations thereof, it will be understood that various changes in form and details may be made therein without departing from the scope of the following claims.

## Claims

1. A memory device comprising:
a memory cell array (210) comprising a plurality of memory cells; and
a control circuit (220) configured to:
control a memory operation on the memory cell array (210) based on a status read command-address signal transmitted from a memory controller (100), the memory controller (100) being external to the memory device (200), and
transmit, based on the status read command-address signal, a pass/fail status signal and a ready/busy status signal to the memory controller (100), wherein the pass/fail status signal and the ready/busy status signal respectively comprise a pass/fail status and a ready/busy status of the memory device (200).

2. The memory device of claim 1, wherein the status read command-address signal has *n* bits, and *n* is a natural number,
wherein an *a^{th}* bit of the *n* bits indicates the ready/busy status and a *b^{th}* bit of the *n* bits indicates the pass/fail status, *a* is a natural number equal to or less than *n,* and *b* is a natural number equal to or less than *n*,
wherein the *a^{th}* bit has a higher priority than the *b^{th}* bit, and
wherein the memory controller (100) is configured to output the *a^{th}* bit earlier than the *b^{th}* bit.

3. The memory device of claim 2, wherein a value of the *a^{th}* bit being equal to 0 corresponds to a busy status and the value of the *a^{th}* bit being equal to 1 corresponds to a ready status, and
wherein a value of the *b^{th}* bit being equal to 0 corresponds to a pass status, and the value of the *b^{th}* bit being equal to 1 corresponds to a fail status.

4. The memory device of claim 3, wherein the memory controller (100) is configured to send an additional status read command-address signal to the memory device (200) based on the value of the *a^{th}* bit being equal to 0 and the value of the *b^{th}* bit being equal to 0.

5. The memory device of claim 3 or 4, wherein the memory controller (100) is configured to send an additional status read command-address signal to the memory device (200) based on the value of the *a^{th}* bit being at a logic low level and the value of the *b^{th}* bit being at the logic low level.

6. The memory device of any one of claims 2 to 5, wherein a value of the *a^{th}* bit being at a logic low level corresponds to a busy status, and the value of the *a^{th}* bit being at a logic high level corresponds to a ready status, and
wherein a value of the *b^{th}* bit being at the logic low level corresponds to a pass status, and the value of the *b^{th}* bit being at the logic high level corresponds to a fail status.

7. The memory device of any one of claims 1 to 6, wherein the memory device (200) comprises a latch circuit (222) configured to store status detection data and to transfer the status detection data to the memory controller (100) based on the status read command-address signal.

8. The memory device of claim 7, wherein the status read command-address signal has m bits, and *m* is a natural number,
wherein an *a^{th}* bit of the *m* bits indicates a ready/busy status and a *b^{th}* bit of the *m* bits indicates a pass/fail status, *a* is a natural number equal to or less than m, and *b* is a natural number equal to or less than m, and
wherein the memory controller (100) is configured to output the *b^{th}* bit before the *a^{th}* bit.

9. The memory device of claim 8, wherein, based on at least one of the *a^{th}* bit or the *b^{th}* bit being changed, a bit value of 1 is added to a *c^{th}* bit, and wherein, based on at least one of the *a^{th}* bit or the *b^{th}* bit being unchanged, a bit value of 0 is added to the *c^{th}* bit.

10. The memory device of claim 9, wherein, based on the *c^{th}* bit being 1, the memory controller (100) is configured to send an additional status read command-address signal to the memory device (200).

11. The memory device of claim 9 or 10, wherein, based on the *c^{th}* bit being at a logic high level, the memory controller (100) is configured to send an additional status read command-address signal to the memory device (200).

12. A memory controller for controlling a memory device (200), the memory controller (100) comprising:
a memory interface (150) configured to:
transfer a status read command-address signal to the memory device (200) through a first bus (B1), the status read command-address signal being used to control a memory operation for the memory device (200), and
transmit to and receive from the memory device (200), through a second bus (B2), data corresponding to the status read command-address; and
a processor (110) configured to receive, based on the status read command-address signal, status data of the memory device (200) from the memory device (200) through the second bus (B2) while a pass/fail status signal and a ready/busy status signal are transferred to the memory controller (100),
wherein the pass/fail status signal and the ready/busy status signal respectively comprise a pass/fail status and a ready/busy status of the memory device (200).

13. The memory controller of claim 12, wherein the status read command-address signal has *n* bits, and *n* is a natural number,
wherein an *a^{th}* bit of the *n* bits indicates a ready/busy status and a *b^{th}* bit of the *n* bits indicates a pass/fail status, *a* is a natural number equal to or less than *n,* and *b* is a natural number equal to or less than *n*,
wherein the *a^{th}* bit has a higher priority than the *b^{th}* bit, and the memory controller (100) is configured to output the *a^{th}* bit before the *b^{th}* bit,
wherein a value of the *a^{th}* bit being equal to 0 corresponds to a busy status, and the value of the *a^{th}* bit being equal to 1 corresponds to a ready status, and
wherein a value of the *b^{th}* bit being equal to 0 corresponds to a pass status, and the value of the *b^{th}* bit being equal to 1 corresponds to a fail status.

14. The memory controller of claim 13, wherein, the value of the *a^{th}* bit being equal to 0 and the value of the *b^{th}* bit being equal to 0, the memory controller (100) is configured to provide an additional status read command-address signal to the memory device (200).

15. An operating method of a memory system comprising a memory controller (100) and a memory device (200), the operating method comprising:
transmitting, by the memory controller (100), a status read command-address signal through a first bus to control an operation of the memory device (200);
transmitting and receiving, by the memory controller (100), data corresponding to the status read command-address signal through a second bus;
receiving, by the memory device (200), the status read command-address signal to detect status data of the memory device (200); and
transferring, by the memory device (200), the status data to the memory controller (100),
wherein the status data includes a pass/fail status and a ready/busy status of the memory device (200).
